# FASCICULE DE BREVET EUROPEEN

(11) **EP 2 636 068 B1**
(45) Date de publication et mention de la délivrance du brevet: **11.03.2020**
(21) Numéro de dépôt: 11787702.7
(22) Date de dépôt: 03.11.2011
(51) Int. Cl.: H01L 27/146, G02B 5/28, H01L 31/0216

(54) **IMAGEUR MONOLITHIQUE MULTISPECTRAL VISIBLE ET INFRAROUGE**
MONOLITHISCHER MULTISPEKTRALER BILDGEBER IM SICHTBAREN UND NAHINFRAROT-BEREICH
MONOLITHIC MULTISPECTRAL VISIBLE-AND-INFRARED IMAGER

(30) Priorité: 03.11.2010 FR 1004314
(43) Date de publication de la demande: 11.09.2013
(73) Titulaire: Commissariat à l'Énergie Atomique et aux Énergies Alternatives, 75015 Paris (FR)
(72) Inventeur: GIFFARD, Benoit, F-38000 Grenoble (FR); CAZAUX, Yvon, F-38100 Grenoble (FR); MOUSSY, Norbert, F-38190 Sainte Agnès (FR)
(74) Mandataire: GIE Innovation Competence Group
(86) Numéro de dépôt international: PCT/FR2011/000587
(87) Numéro de publication internationale: WO 2013/064753

(56) Documents cités:
- WO-A1-2008/012235
- WO-A2-2008/127297
- JP-A- 2 022 973
- US-A- 5 373 182
- US-A1- 2006 124 833
- US-A1- 2007 284 532
- US-A1- 2009 147 101
- US-A1- 2009 200 589

## Description

### Domaine technique de l'invention

L'invention concerne le domaine des capteurs d'image, et plus précisément des imageurs multi spectraux visible et infrarouge, fonctionnant dans des conditions de nuit ou de faible niveau de lumière.

### État de la technique

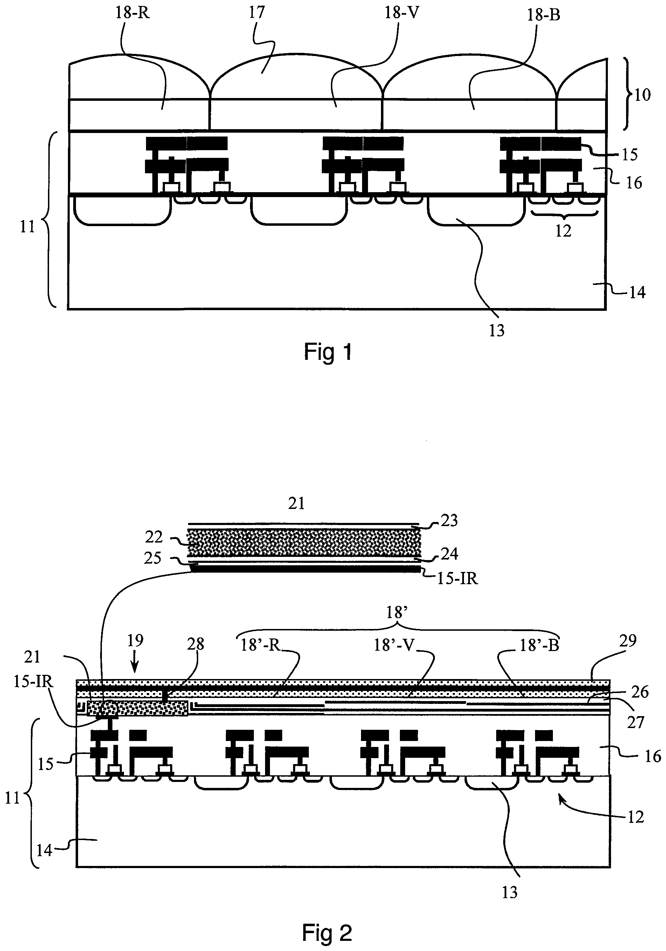

Un capteur d'image permet de produire un signal électronique correspondant point par point à une scène observée. La figure 1 illustre, de façon schématique, en coupe, une structure simplifiée d'un capteur d'image à « pixels actifs » ou APS, en technologie CMOS de l'art antérieur (APS du terme usuel anglais « Active Pixel Sensor »).

Chaque pixel comprend une partie optique 10 assemblée sur un substrat 11. Le substrat 11 comprend un circuit de lecture 12 et une photodiode 13 formée dans une couche en silicium 14. Les circuits de lecture 12 sont reliés aux photodiodes 13 et entre eux à l'aide d'interconnexions 15 qui sont formées au-dessus de la couche 14 dans une couche d'un matériau électriquement isolant 16, comme la silice.

La partie optique 10 comprend des microlentilles 17, qui focalisent le rayonnement incident sur les photodiodes 13 respectives, et une matrice de filtres en résines colorées 18 en correspondance avec la matrice formée par les photodiodes 13. La matrice de filtres comprend des filtres 18-R, 18-V et 18-B correspondant respectivement aux couleurs élémentaires, rouge, vert, et bleu.

Actuellement, les capteurs APS, même à bas coût, permettent d'obtenir une image couleur de grande qualité. Cependant quelques imperfections subsistent encore. En effet, les résines colorées utilisées dans les capteurs APS ne sont pas denses. Par conséquent, une épaisseur assez importante, de l'ordre du micromètre est nécessaire pour un filtrage performant des couleurs élémentaires.

Or, la taille des pixels des capteurs d'image récents est aussi de l'ordre du micromètre. Cette dimension de pixel pose un problème lié à l'effet d'ombrage qui apparaît lorsque le rayonnement arrive à la surface du capteur avec un grand angle incident. Dans ces conditions, les photons traversent un filtre et finissent leur trajectoire dans la photodiode associée au filtre voisin.

Le problème lié à l'épaisseur des résines colorées ralentit considérablement la miniaturisation des capteurs d'image. L'utilisation de résines colorées souffre aussi de son incapacité à filtrer l'infrarouge. De ce fait, il est nécessaire d'ajouter au-dessus de l'ensemble du capteur d'image un filtre supplémentaire pour éliminer la composante infrarouge du rayonnement.

Les capteurs APS rencontrent un autre problème lié à une dégradation de la qualité d'image dans des conditions de nuit ou de faible niveau de lumière. Pour pallier ce problème le recours à la détection en proche infrarouge est fréquent.

La réponse spectrale des photodiodes dépend principalement du choix du matériau semi-conducteur photosensible dans lequel elles sont formées. Les photons ne sont absorbés par le matériau semi-conducteur photosensible que si leur énergie est supérieure à la largeur de la bande interdite. Cette dernière correspond à l'énergie qu'un électron doit absorber, sous la forme d'un photon, afin qu'il puisse quitter la bande de valence vers la bande de conduction. L'électron devient ainsi mobile : c'est un électron photo-généré.

Le matériau semi-conducteur le plus utilisé pour la réalisation des capteurs d'image est le silicium. Toutefois, pour la détection de longueurs d'onde au-delà du visible, l'utilisation d'une couche très épaisse de silicium est nécessaire. Le silicium reste néanmoins transparent pour des longueurs d'onde au-delà du micromètre, et ne peut être utilisé comme un matériau de détection des rayonnements infrarouges.

Pour une détection au-delà d'un micromètre de longueur d'onde, on choisit des matériaux semi-conducteurs ayant une largeur de la bande interdite plus faible que celle du silicium, comme le germanium ou l'arséniure d'indium-gallium (InGaAs). Une couche de 0,5µm d'épaisseur d'InGaAs s'avère suffisante pour absorber 90% du flux à 0,9µm de longueur d'onde. Pour absorber le même flux et le convertir en courant électrique, il est nécessaire d'utiliser une couche de 100µm d'épaisseur de silicium. Une couche d'InGaAs peut détecter jusqu'à 1,6µm de longueur d'onde.

Pour des capteurs d'imagerie infrarouge, des matériaux semi-conducteurs III-V sont généralement utilisés puisqu'ils ont des capacités de photodétection très intéressantes dans cette gamme de longueur d'onde. Ce type de capteurs comprend une partie en silicium ou en un matériau équivalent servant de base à la technologie CMOS, dans laquelle des circuits de lecture sont réalisés.

Un exemple de capteur d'imagerie infrarouge est réalisé en découpant une matrice de photodiodes et de circuits de lecture et en les assemblant selon la technique de puce retournée (« flip chip »). Cependant ce genre de procédé n'est pas adapté à une intégration grande échelle. En effet, un soin particulier doit être apporté au procédé pour résoudre les problèmes d'alignement et les problèmes liés aux contraintes thermo-mécaniques.

Pour atténuer l'impact de ces problèmes, des procédés utilisant un assemblage, à l'aide d'un collage par adhésion moléculaire, peuvent être réalisés. Cet assemblage est décrit, par exemple, dans l'article intitulé « Wafer-scale 3D intégration of InGaAs image sensors with readout circuits », par C. L. Chen et al.- IEEE International Conférence on 3D System Intégration, 2009, p.1-4. Ce genre de procédé reste néanmoins complexe et souffre d'une diminution du rendement du capteur d'image infrarouge.

Aucun matériau semi-conducteur usuel ne permet aujourd'hui de réaliser des photodiodes qui détectent efficacement, à la fois un rayonnement dans la bande du visible et un rayonnement infrarouge. Dans des applications où l'on souhaite traiter à la fois le visible et l'infrarouge, on est contraint de réaliser des capteurs hybrides, comme cela est décrit, par exemple, dans le brevet US5808350. La détection en proche infrarouge, dans ce genre de capteurs, est assurée par une hétérojonction InGaAs/Si. Cette hétérojonction est formée par un collage moléculaire d'une couche d'InGaAs sur une face arrière d'un substrat en silicium. Le substrat en silicium comporte également un détecteur visible et des circuits de lecture formés en face avant. La réalisation d'un tel capteur est complexe. En particulier, la formation d'une hétérojonction InGaAs/Si pour détecter le rayonnement proche infrarouge est difficile à maîtriser.

Par ailleurs, un capteur hybride comportant un détecteur infrarouge à base d'un microbolomètre a également été utilisé pour la détection des rayonnements visible et infrarouge. Ce type de capteurs est décrit, par exemple, dans la demande de brevet US 2007/284532. La détection hybride dans ce capteur est effectuée par un détecteur de rayonnement visible formant un pixel visible et quatre détecteurs de rayonnement infrarouge formant un pixel infrarouge. Les deux types de détecteurs sont réalisés à partir d'un substrat en silicium comportant des zones localisées en oxyde de silicium. Les détecteurs infrarouge sont de type microbolomètre comportant une structure en matériau absorbant les rayonnements infrarouges. L'absorption d'un rayonnement infrarouge engendre une augmentation de la température convertie par un module thermoélectrique en un signal électrique acheminé directement vers un module de traitement.

Le document US 2009/200589 A1 divulgue un capteur d'imagerie comprenant une couche semi-conductrice et une couche de détection d'infrarouge. Un pixel d'imagerie comprend une zone de photodiode formée dans la couche semi-conductrice. La couche de détection d'infrarouge est agencée sur la surface avant de la couche semi-conductrice pour recevoir un rayonnement infrarouge qui se propage de la surface arrière de la couche semi-conductrice à travers le capteur d'imagerie.

Le document US 2006/124833 A1 divulgue un dispositif de détection comprenant une photodiode pour détecter un rayonnement visible et une photodiode pour détecter un rayonnement infrarouge. Les deux photodiodes sont formées dans le même substrat. Un filtre interférentiel est déposé sur une région de la photodiode pour détecter le rayonnement visible.

D'autres dispositifs de détection sont connus des documents US 2009/147101, JP 2 022973, WO 2008/012235, US 5 373 182 et WO 2008/127297.

### Objet de l'invention

Dans certaines applications, on aurait besoin d'un capteur d'image hybride qui permette en outre d'obtenir une image couleur tout en étant facile à réaliser et compact.

On tend à satisfaire ce besoin en prévoyant un dispositif de détection de rayonnement selon la revendication 1.

On prévoit également un procédé de réalisation d'un dispositif de détection de rayonnement selon la revendication 6.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente de manière schématique, en coupe, un capteur d'image APS selon l'art antérieur ;
- la figure 2 représente de manière schématique, en coupe, un mode de réalisation d'un détecteur de rayonnement selon l'invention ;
- les figures 3 à 8 illustrent des étapes successives d'un procédé de réalisation d'un détecteur de rayonnement selon l'invention.

### Description d'un mode de réalisation préféré de l'invention

Pour permettre à un même capteur de réaliser une image classique en couleur de grande qualité et une image avec une grande sensibilité en proche infrarouge, il est préférable d'utiliser les matériaux semi-conducteurs les plus adaptés aux différents spectres visés.

Il est donc avantageux de tirer profit à la fois des capteurs d'image utilisant la technologie CMOS et des capteurs infrarouge à base d'un matériau semi-conducteur convenable, tout en évitant leurs inconvénients.

Afin de réaliser une association d'un capteur d'image couleur classique et d'une photodiode infrarouge grande sensibilité, on envisage une intégration hybride, compatible avec la structure CMOS.

La figure 2, illustre schématiquement un mode de réalisation d'un détecteur de rayonnement qui tend à satisfaire ces contraintes. Il est basé sur un capteur classique du type de la figure 1. Ainsi, le dispositif comprend des éléments semblables à ceux illustrés à la figure 1, désignés par des mêmes références. On retrouve notamment une structure CMOS réalisée dans un substrat 11 comportant une couche en silicium 14 munie d'une face avant et d'une face arrière. On retrouve également, une photodiode 13 et des premier 12-1 et second 12-2 circuits de lecture 12 formés sur la face avant, le premier circuit de lecture 12-1 étant relié à la photodiode 13. Le détecteur de rayonnement comporte une couche électriquement isolante 16 recouvrant la face avant de la couche en silicium 14 de manière à recouvrir les premier et second 12-1 et 12-2 circuits de lecture et la photodiode 13. Le détecteur de rayonnement comporte des pixels associés aux trois couleurs élémentaires, comprenant chacun une photodiode 13. La partie optique comprenant les microlentilles et les filtres en résine 18 de la figure 1 est remplacée par une structure de filtres interférentiels 18', décrite plus en détail ultérieurement.

On entend par trois couleurs élémentaires, trois voies de décomposition spectrale nécessaires à la reproduction des couleurs.

Pour chaque groupe de trois pixels couleur, la structure CMOS de la figure 2 comprend un quatrième pixel 19, incomplet dans la structure CMOS. Ce pixel est incomplet en ce que sa photodiode 13 est inopérante. Le pixel peut même être dépourvu de cette photodiode 13. Ce pixel forme un pixel infrarouge avec les éléments décrits ci-après.

Un photodétecteur infrarouge 21 sous la forme d'un îlot est disposé sur la couche diélectrique d'interconnexion 16, localement au niveau du pixel infrarouge 19. Cet îlot, formant une photodiode infrarouge 21, est réalisé en utilisant un procédé mesa. La photodiode infrarouge 21 est disposée de manière à être décalée latéralement par rapport à la photodiode 13. Il s'agit ici d'une photodiode infrarouge de type PIN (du terme usuel anglais « Positive Intrinsic Negative diode ») qui comporte une couche d'un matériau semi-conducteur photosensible intrinsèque 22 adapté aux infrarouges, interposée entre une couche en matériau semi-conducteur 23 dopé p et une couche en matériau semi-conducteur 24 dopé n. La couche 24 est recouverte par une couche de métallisation 25 de prise de contact de cathode. La prise de contact d'anode est réalisée par une ligne métallique étroite 28 formée dans une couche 29 en matériau diélectrique transparent au rayonnement incident. La couche 29 est disposée au-dessus de la photodiode 21 et des filtres interférentiels 18'.

Les matériaux semi-conducteurs des couches 23 et 24 peuvent êtres identiques ou de natures différentes. De préférence, les couches 23 et 24 sont en phosphure d'indium (InP). De préférence, le matériau photosensible 22 est un matériau semi-conducteur ayant une largeur de la bande interdite inférieure à 0,8 eV. Autrement dit, la photodiode infrarouge 21 est réalisée dans un matériau optimisé pour la détection infrarouge. Ici, le matériau 22 est en alliage d'arséniure de gallium et d'indium (InGaAs) déposé par épitaxie sur la couche 23 en InP, dopée p. La couche 25 et la ligne 28 sont, par exemple, en Cu ou en Ti/Au. La ligne 28 peut également être remplacée par une couche métallique transparente telle que l'Oxyde d'indium à l'Etain (ITO) ou l'oxyde de zinc (ZnO). Cette couche conductrice transparente peut être localement retirée au-dessus du pixel infrarouge pour améliorer la transparence vers ce pixel infrarouge.

Dans le pixel 19, l'une des interconnexions 15 (correspondant à celle qui sert dans chaque autre pixel à prendre le contact avec sa photodiode 13) est en contact avec la couche métallique 25 de la photodiode 21. Ce contact est réalisé par l'intermédiaire d'une métallisation de contact 15-IR à la surface de la couche électriquement isolante 16. La photodiode infrarouge 21 est ainsi reliée à son circuit de lecture 12 en technologie CMOS. Autrement dit, la photodiode infrarouge 21 est disposée sur la couche électriquement isolante 16 et reliée au second circuit de lecture 12-2 via l'interconnexion 15-IR traversant la couche électriquement isolante 16 et débouchant à sa surface. L'ensemble des photodiodes infrarouge 21 est également relié collectivement à la prise de contact d'anode au moyen de la ligne conductrice 28. Cette ligne conductrice est elle-même reliée à un potentiel positif qui polarise l'ensemble des photodiodes infrarouge. Afin de palier les problèmes liés aux filtres en résine, le dispositif détecteur de rayonnement selon l'invention comprend une structure de filtres interférentiels 18' adjacente à la photodiode infrarouge 21, c'est-à-dire recouvrant les photodiodes CMOS 13 de spectre visible sans recouvrir la photodiode infrarouge 21.

Les filtres interférentiels sont, par exemple, semblables à ceux décrits dans le brevet FR2904432. Ils sont formés par un empilement comprenant une alternance d'au moins deux couches métalliques 26 et d'au moins deux couches diélectriques 27. Les couches métalliques peuvent être en argent (Ag) et les couches diélectriques peuvent être en nitrure de silicium (Si₃N₄).

En plus de filtrer la composante infrarouge du rayonnement incident, caractéristique souhaitée pour la détection dans le spectre visible, les filtres interférentiels 18' peuvent également décomposer un rayon lumineux en couleurs élémentaires. De ce fait, le dispositif représenté à la figure 2 peut comporter trois filtres interférentiels 18'-R, 18'-V et 18'-B correspondant à trois couleurs élémentaires. Les filtres 18' sont disposés, dans ce cas, au-dessus de trois photodiodes associées 13. Chacun des trois filtres interférentiels 18'-R, 18'-V et 18'-B permet de filtrer, à la fois la composante infrarouge et deux composantes associées à deux des trois couleurs élémentaires du rayonnement incident. Autrement dit, la structure de filtrage de rayonnement infrarouge 18' a une caractéristique spectrale de transmission correspondant au moins à une des trois voies de décomposition nécessaires à la reproduction des couleurs.

L'épaisseur des filtres interférentiels infrarouge 18' est moins importante que celle des filtres en résine. De ce fait, les filtres interférentiels 18' contribuent avantageusement à la miniaturisation des capteurs d'image selon l'invention.

Comme cela est visible à la figure 2, la photodiode infrarouge 21 et les filtres 18' ont une surface exposée au rayonnement incident dans un même plan. Cet agencement du filtre interférentiel et de la photodiode infrarouge facilite l'atténuation de l'effet d'ombrage provoqué par les angles d'incidence obliques du rayonnement loin du centre du capteur. En effet, la photodiode infrarouge 21 peut être repositionnée comme on repositionne classiquement les filtres par rapport aux photodiodes 13 pour compenser l'incidence oblique du rayonnement.

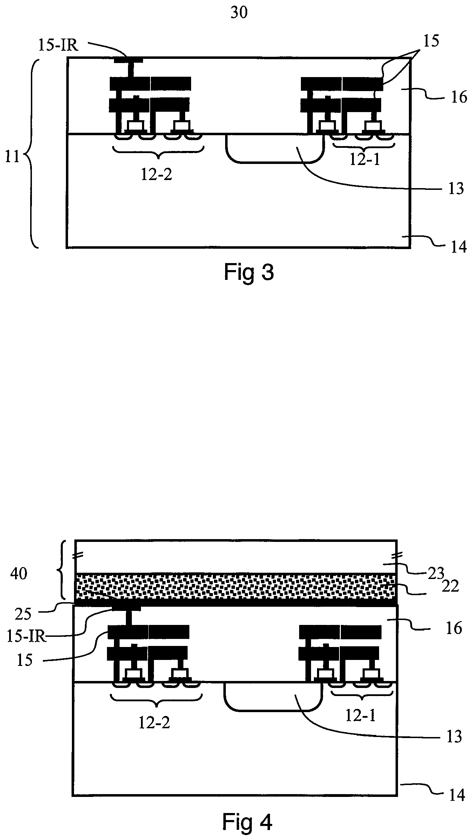

Les figures 3 à 8 illustrent des étapes successives d'un procédé de réalisation d'un détecteur de rayonnement selon l'invention.

La figure 3 représente une structure de départ 30 entièrement réalisée en technologie CMOS, correspondant aux éléments réalisés dans le substrat 11 comportant la couche en silicium 14 qui est munie d'une face avant et d'une face arrière. La couche 16 recouvre la face avant et les premier et second circuits de lecture 12-1 et 12-2 et la photodiode 13. Le circuit de lecture 12-1 est associé à la photodiode de spectre visible 13, et le circuit de lecture 12-2 est associé à la future photodiode infrarouge.

La structure CMOS 30 comporte également le contact métallique 15-IR disposé à la surface du substrat en silicium 11, servant à relier la future photodiode infrarouge à son circuit de lecture 12-2.

À la figure 4, un empilement de couches 40 de photodiode infrarouge est réalisé à base d'un matériau optimisé pour la détection infrarouge, et il est assemblé sur la structure CMOS 30. Comme cela est représenté à la figure 2, cet empilement comprend de préférence une couche intrinsèque 22 d'InGaAs déposée par épitaxie sur un substrat en InP 23 de type p.

Il est connu que les substrats en InP sont, d'un point de vue mécanique, fragiles. De ce fait, ils ne sont disponibles, en général, qu'en plaquettes de 2 ou 3 pouces. Ce sont des dimensions de plaquettes différentes de celles des plaquettes de silicium comprenant des capteurs d'image classiques. Dans ces conditions, il est souhaitable de découper les plaquettes comprenant l'empilement de la photodiode infrarouge avant l'étape d'assemblage. Les plaquettes sont découpées par puces correspondant aux dimensions des capteurs à réaliser. Ainsi, l'ensemble du capteur est, à la figure 4, recouvert par l'empilement 40. Par ailleurs, afin de simplifier la réalisation de l'empilement 40, la métallisation 25, servant de contact de cathode aux futures photodiodes infrarouges, est déposée « pleine plaque » elle s'étend ainsi sur l'ensemble de la face inférieure de l'empilement 40, et ne définit pas encore des photodiodes infrarouges individualisées.

L'assemblage de l'empilement 40 sur la couche électriquement isolante 16 s'effectue de manière que la couche de métallisation 25 soit en contact avec la face avant de la structure CMOS 30 et par la même occasion avec le contact métallique 15-IR. Cet assemblage est réalisé, de préférence, à l'aide d'un collage métal/métal classique.

L'assemblage peut être réalisé par tout moyen permettant de rendre solidaire l'empilement de la photodiode infrarouge avec la structure 30 en assurant une connexion électrique entre le contact métallique 15-IR et la couche de métallisation 25.

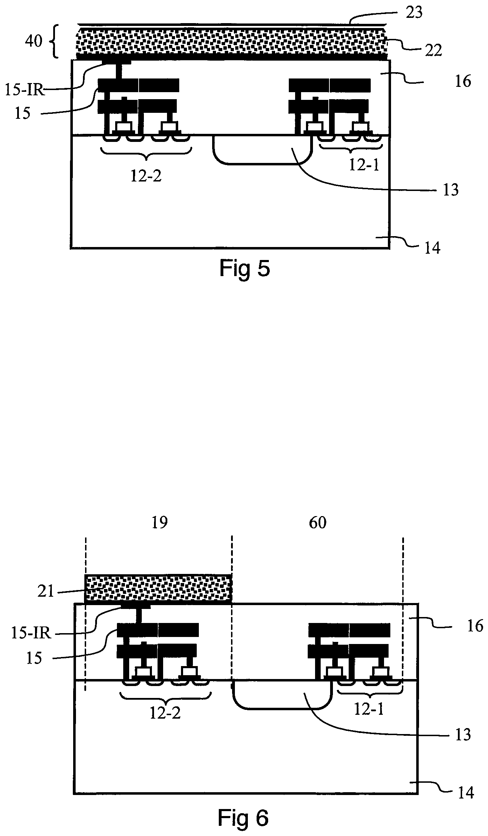

À la figure 5, une grande partie du substrat en InP est éliminée, par exemple par CMP (du terme usuel anglais « chemical-mechanical planarization »). Pour limiter l'épaisseur et les effets d'ombrage associés, uniquement une fine couche d'InP 23 dopé p subsiste au-dessus de la couche d'InGaAs 22.

Comme illustré à la figure 6, un pixel visible 60 et un pixel infrarouge 19 sont formés à la surface de la couche électriquement isolante 16. Les pixels 60 et 19 sont formés par gravure de l'empilement 40. La gravure permet de délimiter un îlot formant la photodiode infrarouge 21. L'empilement 40 est retiré au-dessus de la photodiode visible 13 par cette même gravure. Le pixel visible 60 peut alors être exposé à un rayonnement incident à la face avant.

Le fait d'assembler l'empilement 40 avant la formation de la photodiode infrarouge 21 simplifie le procédé de réalisation. On s'affranchit également des problèmes d'alignement qui peuvent apparaître lors d'un assemblage d'une photodiode infrarouge finalisée à la structure CMOS.

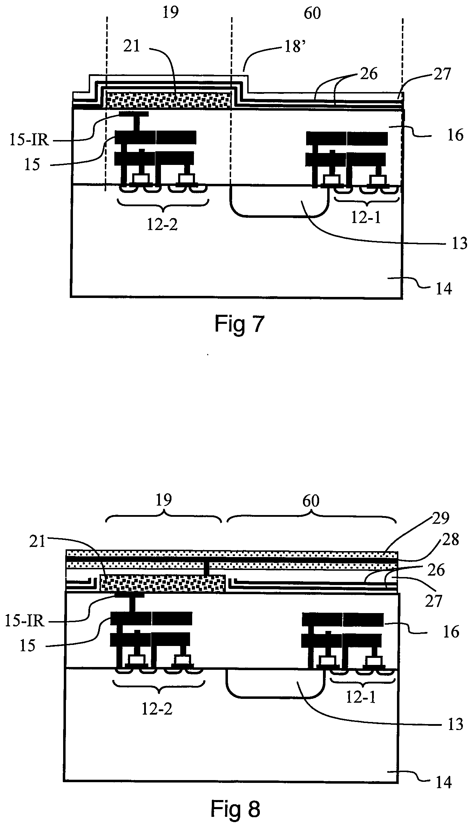

À la figure 7, on forme un filtre interférentiel infrarouge 18' au-dessus des pixels 19 et 60.

Afin de faciliter le procédé de réalisation, le filtre interférentiel 18' est formé sur toute la face avant de la structure de la figure 6. Autrement dit, la structure de filtre interférentiel de rayonnement infrarouge 18' est formée sur la photodiode 13 et sur la photodiode infrarouge 21. En effet, il est plus facile d'effectuer une élimination sélective d'un matériau qu'un dépôt sélectif du même matériau. Ainsi, la photodiode infrarouge 21 est recouverte par le filtre 18' qui la rend inutilisable à ce stade.

À la figure 8 on procède à une élimination sélective du filtre 18' au-dessus de la photodiode infrarouge 21. L'élimination du filtre 18' peut être réalisée par gravure ou toute autre technique connue. De préférence, l'élimination est effectuée par planarisation mécano-chimique (CMP).

Pour réaliser la prise de contact métallique d'anode 28, on dépose une couche de diélectrique 29. A l'aide d'une étape de photolithographie suivie d'une gravure de la couche 29, on définit l'emplacement de la ligne 28 et d'un espace permettant un accès à la photodiode infrarouge 21. Ensuite, une étape de remplissage par un métal est effectuée afin de former la ligne métallique 28. La ligne 28 peut être réalisée par le procédé « damascène » ou tout autre moyen connu. Un contact métallique supérieur, non représenté à la figure 8, est relié à la ligne 28. Il est ensuite ramené en bord du pixel infrarouge pour être relié à un des plots d'interconnexion 15. Après un polissage mécano-chmique (CMP) de la couche 29 et le dépôt d'un matériau de planarisation transparent au rayonnement incident, on pourra, le cas échéant, former des microlentilles au-dessus des pixels 19 et 60. Le dispositif de détection de rayonnement réalisé permet avantageusement de tirer profit, en temps réel, de l'apport d'une détection infrarouge grande sensibilité dans la réalisation d'une image. Le procédé de réalisation du dispositif selon l'invention est simple et compatible avec la technologie CMOS.

De ce fait, le détecteur de rayonnement selon l'invention bénéficie des avantages de la technologie CMOS pour réaliser une image classique couleur et pour multiplexer le courant d'électrons photo-générés par la photodiode infrarouge et les circuits de détection. L'utilisation des filtres interférentiels permet à la fois, de décomposer la composante visible du rayonnement incident en couleurs élémentaires et de filtrer la composante infrarouge. Ce genre de filtre participe avantageusement à simplifier la réalisation du détecteur de rayonnement.

Bien que l'on ait décrit la réalisation de quelques pixels incluant un pixel infrarouge, les techniques décrites ici s'appliquent à la réalisation d'un capteur matriciel comprenant des millions de pixels infrarouges et visibles (couleur ou noir et blanc).

## Revendications

1. Dispositif de détection de rayonnement comprenant :
- une couche en silicium (14) munie d'une face avant et d'une face arrière ;
- des premier (12-1) et second (12-2) circuits de lecture (12) formés sur la face avant de la couche en silicium (14) ;
- une photodiode (13) formée sur la face avant de la couche en silicium (14) et reliée au premier circuit de lecture (12-1);
- une couche électriquement isolante (16) disposée sur la face avant de la couche en silicium (14) de manière à recouvrir les premier et second circuits de lecture (12-1 et 12-2) et la photodiode (13) ;
- une photodiode infrarouge (21) réalisée dans un matériau (22) optimisée pour la détection infrarouge, et disposée sur la couche électriquement isolante (16), la photodiode infrarouge (21) et la photodiode (13) étant décalées latéralement;
- une interconnexion (15, 15-IR) traversant la couche électriquement isolante (16) et débouchant à la surface de la couche électriquement isolante (16), l'interconnexion (15, 15-IR) étant configurée pour relier le second circuit de lecture (12-2) et la photodiode infrarouge (21) ; le dispositif de détection **caractérisé en ce qu'**une structure de filtres interférentiels de rayonnement infrarouge (18') est disposée sur la couche électriquement isolante, de manière à recouvrir la photodiode (13) sans recouvrir la photodiode infrarouge (21), la photodiode infrarouge (21) et la structure de filtres interférentiels de rayonnement infrarouge (18') étant disposées dans un même plan.

2. Dispositif de détection de rayonnement selon la revendication 1, dans lequel la structure de filtres interférentiels de rayonnement infrarouge (18') a une caractéristique spectrale de transmission correspondant à une des trois voies de décomposition nécessaires à la reproduction des couleurs.

3. Dispositif de détection de rayonnement selon la revendication 2, dans lequel trois structures de filtres interférentiels de rayonnement infrarouge (18'-R, 18'-V, 18'-B) correspondant aux trois voies de décomposition nécessaires à la reproduction des couleurs recouvrent chacune une zone photosensible (13) associée comprise dans la couche en silicium (14).

4. Dispositif de détection de rayonnement selon la revendication 1, dans lequel le matériau optimisé pour la détection infrarouge (22) est un matériau ayant une largeur de la bande interdite inférieure à 0,8 eV.

5. Dispositif de détection de rayonnement selon la revendication 1, dans lequel la structure de filtres interférentiels de rayonnement infrarouge (18') est formée à partir d'un empilement comprenant une alternance de couches métalliques (26) et de couches diélectriques (27).

6. Procédé de réalisation d'un dispositif de détection de rayonnement comprenant les étapes suivantes :
- prévoir une couche en silicium (14) munie d'une face avant et d'une face arrière et comprenant une couche électriquement isolante (16) recouvrant la face avant de la couche en silicium (14) et des premier et second circuits de lectures (12-1, 12-2) et une photodiode (13) formés sur la face avant de la couche en silicium (14), la photodiode (13) étant reliée au premier circuit de lecture (12-1);
- prévoir un empilement de couches (40) de photodiode infrarouge, à base d'un matériau optimisé pour la détection infrarouge (22) ;
- assembler l'empilement de couches (40) sur la couche électriquement isolante (16) ;
- graver l'empilement de couches (40) au-dessus de la photodiode (13) en laissant subsister un îlot de l'empilement, formant une photodiode infrarouge (21) ;
- former une structure de filtres interférentiels de rayonnement infrarouge (18') sur la couche électriquement isolante (16) de manière à recouvrir la photodiode (13) et à recouvrir la photodiode infrarouge (21) ;
- retirer la structure de filtres interférentiels de rayonnement infrarouge (18') au-dessus de la photodiode infrarouge (21), la structure de filtres interférentiels de rayonnement infrarouge (18') et la photodiode infrarouge (21) étant disposées dans un même plan; et
former une interconnexion (15, 15-IR) traversant la couche électriquement isolante (16) et débouchant à la surface de la couche électriquement isolante (16), ladite interconnexion (15, 15-IR) étant configurée pour relier le second circuit de lecture (12-2) à la photodiode infrarouge (21).

7. Procédé de réalisation d'un dispositif de détection de rayonnement selon la revendication 6 dans lequel un contact métallique (15-IR) est formé à la surface de la couche électriquement isolante (16) de manière que, lors de l'étape d'assemblage, le contact métallique relie la photodiode infrarouge (21) au second circuit de lecture (12-2) réalisé dans ladite couche en silicium (14).

## Patentansprüche

1. Vorrichtung zur Detektion von Strahlung, umfassend:
- eine Schicht aus Silicium (14), die mit einer vorderen Fläche und einer hinteren Fläche ausgestattet ist;
- eine erste (12-1) und zweite (12-2) Leseschaltung (12), die auf der vorderen Fläche der Schicht aus Silicium (14) gebildet sind;
- eine Photodiode (13), die auf der vorderen Fläche der Schicht aus Silicium (14) gebildet ist und mit der ersten Leseschaltung (12-1) verbunden ist;
- eine elektrisch isolierende Schicht (16), die auf der vorderen Fläche der Schicht aus Silicium (14) angeordnet ist, um die erste und zweite Leseschaltung (12-1 und 12-2) und die Photodiode (13) zu bedecken;
- eine Infrarot-Photodiode (21), die aus einem Material (22) hergestellt ist, das für die Infrarot-Detektion optimiert ist, und auf der elektrisch isolierenden Schicht (16) angeordnet ist, wobei die Infrarot-Photodiode (21) und die Photodiode (13) lateral versetzt sind;
- eine Zwischenverbindung (15, 15-IR), welche die elektrisch isolierende Schicht (16) durchquert und zu der Fläche der elektrisch isolierenden Schicht (16) führt, wobei die Zwischenverbindung (15, 15-IR) dafür ausgelegt ist, um die zweite Leseschaltung (12-2) und die Infrarot-Photodiode (21) zu verbinden;
wobei die Detektionsvorrichtung **dadurch gekennzeichnet ist, dass** eine Struktur von Interferenzfiltern für Infrarot-Strahlung (18') auf der elektrisch isolierenden Schicht angeordnet ist, um die Photodiode (13) zu bedecken, ohne die Infrarot-Photodiode (21) zu bedecken, wobei die Infrarot-Photodiode (21) und die Struktur von Interferenzfiltern für Infrarot-Strahlung (18') in derselben Ebene angeordnet sind.

2. Vorrichtung zur Detektion von Strahlung nach Anspruch 1, wobei die Struktur von Interferenzfiltern für Infrarot-Strahlung (18') eine Spektralübertragungscharakteristik aufweist, welche einer von drei Zerlegungswegen entspricht, die für die Reproduktion von Farben notwendig sind.

3. Vorrichtung zur Detektion von Strahlung nach Anspruch 2, wobei drei Strukturen von Interferenzfiltern für Infrarot-Strahlung (18'-R, 18'-V, 18'B), welche den drei Zerlegungswegen entsprechen, die für die Reproduktion von Farben notwendig sind, jeweils eine assoziierte photoempfindliche Zone (13) bedecken, die in der Schicht aus Silicium (14) enthalten ist.

4. Vorrichtung zur Detektion von Strahlung nach Anspruch 1, wobei das Material (22), das für die Infrarot-Detektion optimiert ist, ein Material mit einer Bandlückenbreite von weniger als 0,8 eV ist.

5. Vorrichtung zur Detektion von Strahlung nach Anspruch 1, wobei die Struktur von Interferenzfiltern für Infrarot-Strahlung (18') aus einem Stapel gebildet ist, der abwechselnd metallische Schichten (26) und dielektrische Schichten (27) umfasst.

6. Verfahren zur Herstellung einer Vorrichtung zur Detektion von Strahlung, umfassend die folgenden Schritte:
- Bereitstellen einer Schicht aus Silicium (14), die mit einer vorderen Fläche und einer hinteren Fläche ausgestattet ist und eine elektrisch isolierende Schicht (16) umfasst, welche die vordere Fläche der Schicht aus Silicium (14) und eine erste und zweite Leseschaltung (12-1, 12-2) und eine Photodiode (13) bedeckt, die auf der vorderen Fläche der Schicht aus Silicium (14) gebildet sind, wobei die Photodiode (13) mit der ersten Leseschaltung (12-1) verbunden ist;
- Bereitstellen eines Stapels von Schichten (40) der Infrarot-Photodiode, auf der Basis eines Materials (22), das für die Infrarot-Detektion optimiert ist;
- Assemblieren des Stapels von Schichten (40) auf der elektrisch isolierenden Schicht (16);
- Ätzen des Stapels von Schichten (40) über der Photodiode (13), indem eine Insel des Stapels zurückgelassen wird, die eine Infrarot-Photodiode (21) bildet;
- Bilden einer Struktur von Interferenzfiltern für Infrarot-Strahlung (18') auf der elektrisch isolierenden Schicht (16), um die Photodiode (13) zu bedecken, und um die Infrarot-Photodiode (21) zu bedecken;
- Entfernen der Struktur von Interferenzfiltern für Infrarot-Strahlung (18') über der Infrarot-Photodiode (21), wobei die Struktur von Interferenzfiltern für Infrarot-Strahlung (18') und die Infrarot-Photodiode (21) in derselben Ebene angeordnet sind; und
Bilden einer Zwischenverbindung (15, 15-IR), welche die elektrisch isolierende Schicht (16) durchquert und zu der Fläche der elektrisch isolierenden Schicht (16) führt, wobei die Zwischenverbindung (15, 15-IR) dafür ausgelegt ist, die zweite Leseschaltung (12-2) mit der Infrarot-Photodiode (21) zu verbinden.

7. Verfahren zur Herstellung einer Vorrichtung zur Detektion von Strahlung nach Anspruch 6, wobei ein metallischer Kontakt (15-IR) auf der Fläche der elektrisch isolierenden Schicht (16) gebildet wird, damit, in dem Assemblierungsschritt, der metallische Kontakt die Infrarot-Photodiode (21) mit der zweiten Leseschaltung (12-2) verbindet, die in der Schicht aus Silicium (14) hergestellt wird.

## Claims

1. Device for detecting radiation, comprising:
- a silicon layer (14) with a front side and a back side;
- first (12-1) and second (12-2) read-out circuits (12) formed on the front side of the silicon layer (14);
- a photodiode (13) formed on the front side of the silicon layer (14) and connected to the first read-out circuit (12-1);
- an electrically insulating layer (16) placed on the front side of the silicon layer (14) so as to cover the first and second read-out circuits (12-1 and 12-2) and the photodiode (13);
- an infrared photodiode (21) produced in a material (22) optimized for infrared detection, and placed on the electrically insulating layer (16), the infrared photodiode (21) and the photodiode (13) being laterally offset;
- an interconnect (15, 15-IR) that passes through the electrically insulating layer (16) and that opens onto the surface of the electrically insulating layer (16), the interconnect (15, 15-IR) being configured to connect the second read-out circuit (12-2) and the infrared photodiode (21);
the detecting device being **characterized in that** a structure (18') of interference filters of infrared radiation is placed on the electrically insulating layer so as to cover the photodiode (13) without covering the infrared photodiode (21), the infrared photodiode (21) and the structure (18') of interference filters of infrared radiation being placed in one and the same plane.

2. Device for detecting radiation according to Claim 1, wherein the structure (18') of interference filters of infrared radiation has a spectral transmission characteristic corresponding to one of the three channels of decomposition that are necessary for the reproduction of colours.

3. Device for detecting radiation according to Claim 2, wherein three structures (18'-R, 18'-V, 18'-B) of interference filters of infrared radiation corresponding to the three channels of decomposition that are necessary for the reproduction of colours each cover an associated photosensitive region (13) comprised in the silicon layer (14).

4. Device for detecting radiation according to Claim 1, wherein the material (22) optimized for the infrared detection is a material having a bandgap width smaller than 0.8 eV.

5. Device for detecting radiation according to Claim 1, wherein the structure (18') of interference filters of infrared radiation is formed from a stack comprising an alternation of metal layers (26) and of dielectric layers (27).

6. Process for producing a device for detecting radiation, comprising the following steps:
- providing a silicon layer (14) with a front side and a back side and comprising an electrically insulating layer (16) covering the front side of the silicon layer (14) and first and second read-out circuits (12-1, 12-2) and a photodiode (13), which are formed on the front side of the silicon layer (14), the photodiode (13) being connected to the first read-out circuit (12-1);
- providing an infrared-photodiode stack (40) of layers, based on a material (22) optimized for the infrared detection;
- assembling the stack (40) of layers and the electrically insulating layer (16);
- etching the stack (40) of layers above the photodiode (13) while leaving behind an island of the stack, forming an infrared photodiode (21);
- forming a structure (18') of interference filters of infrared radiation on the electrically insulating layer (16) so as to cover the photodiode (13) and to cover the infrared photodiode (21);
- removing the structure (18') of interference filters of infrared radiation above the infrared photodiode (21), the structure (18') of interference filters of infrared radiation and the infrared photodiode (21) being placed in one and the same plane; and
- forming an interconnect (15, 15-IR) that passes through the electrically insulating layer (16) and that opens onto the surface of the electrically insulating layer (16), said interconnect (15, 15-IR) being configured to connect the second read-out circuit (12-2) to the infrared photodiode (21).

7. Process for producing a device for detecting radiation at according to Claim 6, wherein a metal contact (15-IR) is formed on the surface of the electrically insulating layer (16) so that, in the assembling step, the metal contact connects the infrared photodiode (21) to the second read-out circuit (12-2) produced in said silicon layer (14).
